# EUROPÄISCHE PATENTSCHRIFT

(11) **EP 0 367 864 B1**
(45) Veröffentlichungstag und Bekanntmachung des Hinweises auf die Patenterteilung: **17.02.1993**
(21) Anmeldenummer: 88118879.1
(22) Anmeldetag: 11.11.1988
(51) Int. Cl.: H03H 9/64

(54) **Oberflächenwellenfilter mit änderbarem Durchlassbereich**
Surface acoustic wave fibre with variable bandpass characteristics
Dispositif à ondes acoustiques de surface à bande passante variable

(43) Veröffentlichungstag der Anmeldung: 16.05.1990
(73) Patentinhaber: SIEMENS AKTIENGESELLSCHAFT, 80333 München (DE)
(72) Erfinder: Ehrmann-Falkenau, Ekkehard, Dipl.-Ing. Dr. tech., D-8000 München 83 (DE); Rott, Karlheinz, Dipl.-Mathem., D-8000 München 2 (DE); Zibis, Peter, Dipl.-Ing., D-8000 München 83 (DE); Schott, Wilfried, Dipl.-Math., D-8000 München 40 (DE)

(56) Entgegenhaltungen:
- EP-A- 0 065 150
- DE-A- 2 132 985
- GB-A- 1 512 790

## Beschreibung

Oberflächenwellenfilter sind z.B. durch das Datenbuch "Oberflächenwellenfilter für Fernsehanwendungen", Datenbuch 1987/1988, Herausgeber Siemens AG, bekannt. Sie stellen integrierte, passive Bauelemente mit Bandfiltercharakteristik dar, deren Funktion auf der Interferenz von mechanischen Oberflächenwellen beruht, die sich längs der Oberfläche eines piezoelektrischen Materials ausbreiten. Ihr Aufbau zeichnet sich durch ein einkristallines, piezoelektrisches Substrat, vorzugsweise ein Lithiumniobat-Substrat aus, auf das eine Metallschicht, normalerweise Aluminiumschicht, aufgetragen, z.B. aufgedampft ist, aus der beispielsweise mittels Fotoätztechnik piezoelektrische Ein- und Ausgangswandler, sogenannte Interdigitalwandler herausgearbeitet sind. Diese bestehen aus mehreren metallisierten kammartigen Elektroden, d.h. aus Elektroden mit Sammelschienen bzw. sogenannten Busbars und senkrecht zu diesen ausgerichteten Fingern, die sich in den aktiven Bereichen der Wandler jeweils mit Fingern der Elektroden unterschiedlicher Polarität überlappen. Das Substrat an sich ist auf einen Metallträger aufgeklebt. Die Kontaktierung der Ein- und Ausgangswandler mit den nach außen führenden Anschlüssen bzw. Pins erfolgt dabei über Bonddrähte.

Im Betrieb dieser Oberflächenwellenfilter wird ein in den Eingangswandler eingegebenes elektrisches Signal in eine mechanische Oberflächenwelle umgewandelt, die auf der Oberfläche bzw. in der oberflächennahen Schicht des Substrats zum Ausgangswandler läuft, der die Oberflächenwelle wiederum in ein elektrisches Signal umwandelt. Die üblichen Wandler besitzen Interdigitalstrukturen mit Laufzeiteffekten und zeichnen sich durch stark frequenzabhängige Eigenschaften aus, so daß aufgrund entsprechender Ausbildung der Fingerstrukturen der Wandler eine Filterwirkung für elektrische Signale (Durchlaßbereich) erreichbar ist.

Die Filterwirkung der Oberflächenwellenfilter wird dabei im wesentlichen durch die Durchgangsdämpfung bzw. Durchlaßkurve (Durchlaßbereich), d.h. die über der Frequenz aufgetragene Dämpfung, die im Filter-Durchlaßbereich minimal ist, bestimmt. Liegt bei bekanntem Einkristallsubstrat die grundsätzliche Filterstruktur, d.h. die Art und Lage der Wandler sowie der Einsatz weiterer zur Signalverarbeitung von Oberflächenwellen geeigneter Komponenten fest, so kann eine Veränderung des Durchlaßbereichs des Filters nur durch Veränderung der inneren Struktur eines oder beider Wandler, d.h. z.B. durch Änderung des Fingerabstandes, der Apertur oder Wichtung der Wandlerfinger erreicht werden; es sei denn, daß durch externe Beschaltung des Filters eine Durchlaßbereich-Änderung möglich ist.

In bestimmten Fällen, so z.B. bei Multistandard-Fernsehempfängern, bei denen beispielsweise neben PAL-Fernsehsendungen auch solche empfangen werden können, die auf einer anderen Norm, z.B. I-, L-oder M-Norm basieren, ist je Norm bzw. Standard ein ZF-Filter mit einem dieser Norm entsprechenden Durchlaßbereich erforderlich, wobei der Anwender oder ggf. bereits der Hersteller der Fernsehempfänger jeweils auf das entsprechende ZF-Filter umschaltet bzw. eine Auswahl aus den möglichen Normen trifft. Zu diesen Filtern zählen sogenannte Doppelvideofilter mit zwei Videokanälen unterschiedlicher Videobandbreite und mit je zwei Ein- und Ausgängen, wobei der Anwender wahlweise auf einen dieser Kanäle schaltet.

Der vorliegenden Erfindung liegt die Aufgabe zugrunde, die zur wahlweisen Umschaltung erforderliche hohe Anzahl von Filtern unterschiedlichen Durchlaßbereichs und den damit verbundenen hohen externen Schaltungsaufwand durch ein einzelnes Oberflächenwellenfilter zu ersetzen, das zwar gleichfalls jedoch mit erheblich geringerem Aufwand geschaltet werden muß.

Zur Lösung dieser Aufgabe sieht die Erfindung ein Oberflächenwellenfilter mit mindestens zwei parallelen Spuren mit Ein= und Ausgangswandlern vor, wobei die Busbars eines Ein= oder Ausgangswandlers einer Spur an unterschiedlichem Potential liegen und ein Busbar, und zwar gleichfalls eines Ein- bzw. Ausgangswandlers mindestens einer weiteren Spur an einem dieser Potentiale liegt, dessen anderer Busbar wahlweise an eines dieser Potentiale anschaltbar ist, so daß der resultierende Durchlaßbereich des Filters durch Zu- und Abschaltung der einzelnen Spuren, die jeweils unterschiedliche Durchlaßbereiche haben, wählbar ist.

Soll beispielsweise zwischen zwei Durchlaßbereichen geschaltet werden, so genügen zwei parallele Spuren, wobei die Busbars des Eingangs- oder des Ausgangswandlers der ersten Spur an unterschiedlichem Potential liegen und ein Busbar des Eingangs- oder Ausgangswandlers der zweiten Spur an einem der beiden Potentiale und dessen anderer Busbar wahlweise an einem dieser Potentiale liegen.

Die Ausgangswandler der Spuren können dabei parallel oder in Serie geschaltet sein.

Die Erfindung wird nachstehend anhand eines Ausführungsbeispieles näher erläutert. Es zeigt:
- FIG 1: ein Oberflächenwellenfilter nach der Erfindung in Draufsicht und schematischer Darstellung,
- FIG 2: die Durchlaßkurve des Filters gemäß FIG 1 und die Durchlaßkurven seiner einzelnen Spuren.

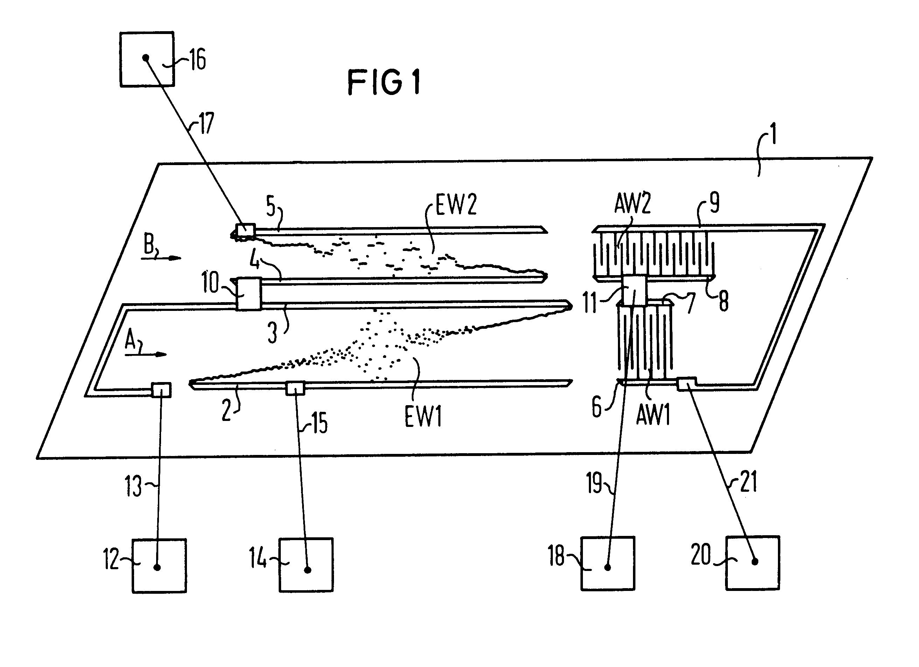

Das Oberflächenwellenfilter gemäß FIG 1 besitzt ein einkristallines, piezoelektrisches Substrat, vorzugsweise ein Lithiumniobatsubstrat 1 mit zwei auf seiner Oberfläche angeordneten parallelen Spuren A und B. Jede Spur besteht aus einem Eingangswandler EW1 bzw. EW2 mit in der Zeichnung schematisch angedeuteter Interdigitalstruktur und mit Sammelschienen bzw. Busbars 2, 3 bzw. 4, 5.

Die bei 10 miteinander kontaktierten Busbars 3, 4 und Busbar 2 liegen über Bonddrähte 13 bzw. 15 an den eingangsseitigen Anschlüssen 12 bzw. 14. Busbar 5 ist über einen Bonddraht 17 mit dem als Schalteingang dienenden Anschluß 16 verbunden.

Die Ausgangswandler AW1 und AW2 sind im gezeichneten Ausführungsbeispiel parallel geschaltet. Hierzu sind die Busbars 7, 8 über einen Kontakt 11 miteinander und über einen Bonddraht 19 mit dem Anschluß 18 und die miteinander kontaktierten Busbars 6, 9 über einen Bonddraht 21 mit dem Anschluß 20 kontaktiert.

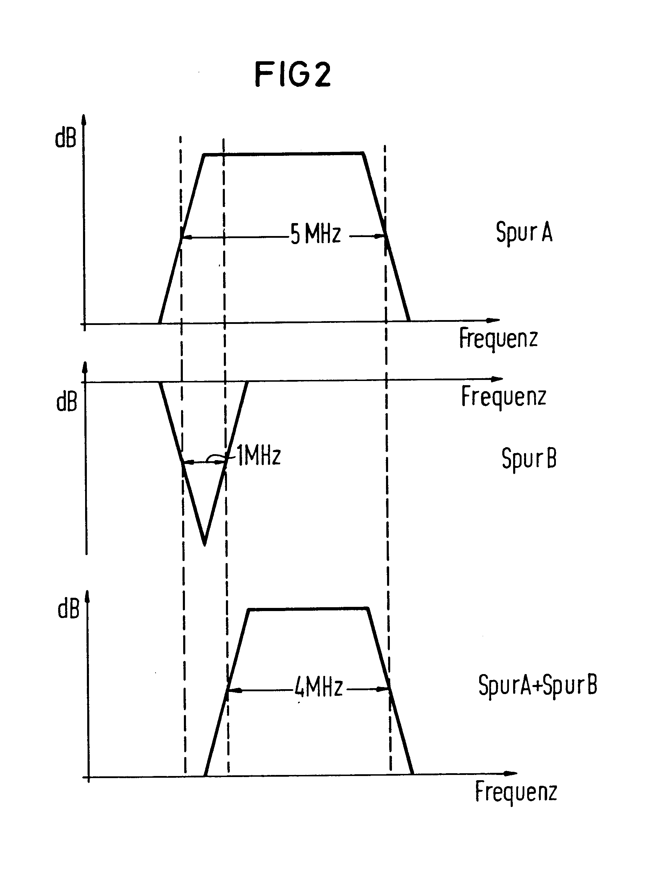

Die Wirkungsweise des schaltbaren Videofilters nach FIG 1 wird anhand von FIG 2 im folgenden erläutert.

Im Filter nach FIG 1 ist die Spur A für einen gegenüber Spur B größeren Durchlaßbereich ausgelegt. Überträgt man in Spur A das Signal größerer Bandbreite, z.B. das der B/G-Norm entsprechende Signal einer Bandbreite von 5 MHz und in Spur B das Differenzsignal - Bandbreite 1 MHz - zur in der M-Norm üblichen 4 MHz Bandbreite, so erhält man am Filterausgang das entsprechende 4 MHz breite Signal.

Voraussetzung hierfür ist, daß die Spur A stets elektrisch aktiv ist, d.h. die Busbars 3, 4 der Eingangswandler EW1 und EW2 an höherem Potential und die Busbars 2, 5 an niedrigerem Potential d.h. üblicherweise an Masse liegen. Bedingt durch die Parallelschaltung der beiden Ausgangswandler AW1 und AW2 addieren sich auf diese Weise die Signale beider Spuren. Falls nur der Eingangswandler EW1 aktiviert wird, d.h. für den Fall, daß Busbar 5 nicht am Potential des Busbars 2 liegt, wird ausschließlich das Signal größerer Bandbreite übertragen.

Durch Zuschaltung weiterer Spuren läßt sich die Wahlmöglichkeit in gewünschter Weise erhöhen.

## Patentansprüche

1. Oberflächenwellenfilter mit änderbarem Durchlaßbereich, **dadurch gekennzeichnet,** daß mindestens zwei parallele Spuren (A, B) mit Ein= und Ausgangswandlern (EW1, EW2 bzw. AW1, AW2) vorgesehen sind, daß die Busbars (2, 3) eines Wandlers (EW1) einer Spur (A) an unterschiedlichem Potential liegen, und daß ein Busbar (4) eines Wandlers (EW2) mindestens einer weiteren Spur (B) an einem der beiden Potentiale liegt, dessen anderer Busbar (5) wahlweise an eines dieser Potentiale anschaltbar ist, so daß der Durchlaßbereich des Filters durch Zu- und Abschaltung der einzelnen Spuren (A, B) unterschiedlichen Durchlaßbereichs wählbar ist.

2. Oberflächenwellenfilter nach Anspruch 1, **dadurch gekennzeichnet,** daß zwei parallele Spuren (A, B) vorgesehen sind, daß die Busbars (2, 3) des Eingangswandlers (EW1) der ersten Spur (A) an unterschiedlichem Potential liegen, und daß ein Busbar (4) des Eingangswandlers (EW2) der zweiten Spur (B) an einem der beiden Potentiale und dessen anderer Busbar (5) wahlweise an einem dieser Potentiale liegen.

3. Oberflächenwellenfilter nach Anspruch 1, **dadurch gekennzeichnet,** daß zwei parallele Spuren (A, B) vorgesehen sind, daß die Busbars (6, 7) des Ausgangswandlers (AW1) der ersten Spur (A) an unterschiedlichem Potential liegen und daß ein Busbar (8) des Ausgangswandlers (AW2) der zweiten Spur (B) an einem der beiden Potentiale und dessen anderer Busbar (9) wahlweise an einem dieser Potentiale liegen.

4. Oberflächenwellenfilter nach Anspruch 2 oder 3, **dadurch gekennzeichnet,** daß die Ausgangs-wandler (AW1, AW2) der zwei Spuren (A, B) parallel geschaltet sind.

5. Oberflächenwellenfilter nach Anspruch 2 oder 3, **dadurch gekennzeichnet,** daß die Ausgangswandler der zwei Spuren (A, B) in Serie geschaltet sind.

6. Oberflächenwellenfilter nach Anspruch 1 und einem der vorhergehenden Ansprüche, **gekennzeichnet** durch die Verwendung als ZF-Filter für Multistandard-Fernsehempfänger, derart, daß je gewünschter Norm das ZF-Filter in den entsprechenden Durchlaßbereich umschaltbar ist.

## Claims

1. Surface acoustic wave filter having a variable passband, characterised in that at least two parallel tracks (A, B) having input and output transducers (EW1, EW2 and AW1, AW2, respectively) are provided, in that the bus-bars (2, 3) of one transducer (EW1) of one track (A) are at a different potential, and in that one bus-bar (4) of one transducer (EW2) of at least one further track (B) is at one of the two potentials, the other bus-bar (5) of which transducer can be selectively connected to one of these potentials, so that the passband of the filter can be selected by connecting and disconnecting the individual tracks (A, B) of different passband.

2. Surface acoustic wave filter according to Claim 1, characterised in that two parallel tracks (A, B) are provided, in that the bus-bars (2, 3) of the input transducer (EW1) of the first track (A) are at a different potential, and in that one bus-bar (4) of the input transducer (EW2) of the second track (B) is at one of the two potentials, and the other bus-bar (5) of said transducer is selectively at one of these potentials.

3. Surface acoustic wave filter according to Claim 1, characterised in that two parallel tracks (A, B) are provided, in that the bus-bars (6, 7) of the output transducer (AW1) of the first track (A) are at a different potential, and in that one bus-bar (8) of the output transducer (AW2) of the second track (B) is at one of the two potentials and the other bus-bar (9) of said transducer is selectively at one of these potentials.

4. Surface acoustic wave filter according to Claim 2 or 3, characterised in that the output transducers (AW1, AW2) of the two tracks (A, B) are connected in parallel.

5. Surface acoustic wave filter according to Claim 2 or 3, characterised in that the output transducers of the two tracks (A, B) are connected in series.

6. Surface acoustic wave filter according to Claim 1 and one of the preceding claims, characterised by use as a IF filter for multi-standard television receivers in such a way that the IF filter can be switched over into the corresponding passband depending on a desired standard.

## Revendications

1. Filtre à ondes acoustiques de surface comportant une bande passante modifiable, caractérisé par le fait qu'il est prévu au moins deux pistes parallèles (A,B) comportant des transducteurs d'entrée et de sortie (EW1,EW2 et AW1,AW2), que les barres omnibus (2,3) d'un transducteur (EW1) d'une piste (A) sont placées à des potentiels différents, qu'une barre omnibus (4) d'un transducteur (EW2) d'au moins une autre piste (B) est placée à l'un des deux potentiels tandis que l'autre barre omnibus (5) peut être raccordée au choix à l'un de ces potentiels de sorte que la bande passante du filtre peut être sélectionnée au moyen du raccordement et du débranchement des différentes pistes (A,B) possédant des bandes passantes différentes.

2. Filtre à ondes de surface suivant la revendication 1, caractérisé par le fait qu'il est prévu deux pistes parallèles (A,B), que les barres omnibus (2,3) du transducteur d'entrée (EW1) de la première piste (A) sont placées à des potentiels différents, et qu'une barre omnibus (4) du transducteur d'entrée (EW2) de la seconde piste (B) est placée à l'un de ces deux potentiels tandis que l'autre barre omnibus (5) est placée au choix à l'un de ces potentiels.

3. Filtre à ondes de surface suivant la revendication 1, caractérisé par le fait qu'il est prévu deux pistes parallèles (A,B), que les barres omnibus (6,7) du transducteur de sortie (AW1) de la première piste (A) sont placés à des potentiels différents et qu'une barre omnibus (8) du transducteur de sortie (AW2) de la seconde piste (B) est placée à l'un de ces deux potentiels tandis que l'autre barre omnibus (9) est placée au choix à l'un de ces potentiels.

4. Filtre à ondes de surface suivant la revendication 2 ou 3, caractérisé par le fait que les transducteurs de sortie (AW1,AW2) des deux pistes (A,B) sont branchés en parallèle.

5. Filtre à ondes de surface suivant la revendication 2 ou 3, caractérisé par le fait que les transducteurs de sortie des deux pistes (A,B) sont branchés en série.

6. Filtre à ondes de surface suivant la revendication 1 et l'une des revendications précédentes, caractérisé par son utilisation en tant que filtre de fréquences moyennes pour des récepteurs de télévision à normes multiples de manière qu'en fonction de la norme désirée, le filtre de fréquences intermédiaires puisse être commuté dans la bande passante correspondante.
